# EUROPEAN PATENT APPLICATION

(11) **EP 1 681 369 A1**
(43) Date of publication of application: **19.07.2006**
(21) Application number: 04788317.8
(22) Date of filing: 29.09.2004
(51) Int. Cl.: C23C 14/58, C23C 16/56

(54) **METAL THIN FILM CHIP PRODUCTION METHOD AND METAL THIN FILM CHIP PRODUCTION DEVICE**

(30) Priority: 30.09.2003 JP 2003341211
(71) Applicant: Japan Science and Technology Agency, Kawaguchi-shi, Saitama 332-0012 (JP)
(72) Inventor: SUDA, Yasuo, Kagoshima 890-0005 (JP); SUEYOSHI, Hidekazu, Kagoshima 890-0065 (JP)
(74) Representative: Bentz, Jean-Paul
(86) International application number: PCT/JP2004/014251
(87) International publication number: WO 2005/031031

(57) **Abstract**

In order to realize the metallic thin film chip producing method, the metallic thin film chip producing apparatus, and the metallic thin film, each of which allows the excessive unevenness of the metallic thin film to be flattened at low cost, the metallic thin film chip producing apparatus according to the present invention includes, in its vessel (9), pressing means (13) having an insulating substrate (3) and a pressing member (4), a chip placement table (5), and a heater (12) having a coil (7) and a power source (8) for supplying an alternating current to the coil (7). Further, the vessel (9) is provided with a vacuum pump (11) for exhausting air from the vessel (9). A magnetic flux generated by the coil (7) penetrates the metallic thin film (1) of the metallic thin film chip (10) placed on the placement table (5). When the magnetic flux penetrates the metallic thin film (1), an eddy current is induced in the metallic thin film (1) due to electromagnetic induction. The metallic thin film (1) is heated to its fusing point or the vicinity of the fusing point by the eddy current. Further, a load exerted by the insulating pressing member (5) causes a surface profile of the insulating substrate (2) or the insulating substrate (3) to be transcribed onto the metallic thin film (1) so that the metallic thin film (1) is flattened.

## Description

### TECHNICAL FIELD

The present invention relates to a metallic thin film chip producing method and a metallic thin film chip producing apparatus.

### BACKGROUND ART

In a conventionally adopted surface plasmon resonance (SPR), mutual interaction of ligand and analite that are fixed on a gold thin film of a gold thin film chip is optically observed. In the SPR, how the mutual interaction of ligand formed on the gold thin film and analite coupled to ligand varies is optically observed. It is general that the gold thin film on the gold thin film chip is formed by vapor deposition.

Note that, SPC Electronics Corporation mentions a high frequency induction heater, which heats metal, on its website column "Introduction of High Frequency Induction Heater" ([online], [searched on May 16, 2005], Internet URL: http:/ /www.spc.jp/heating/tec.002.htm).

Further, Japanese Unexamined Patent Publication No. 254904/2003 *(Tokukai* 2003-254904)(Publication date: September 10, 2003), Japanese Unexamined Patent Publication No. 161694/2003 (*Tokukai* 2003-161694)(Publication date: June 6, 2003), Japanese Unexamined Patent Publication No. 75447/2003 *(Tokukai* 2003-75447)(Publication date: March 12, 2003), Japanese Unexamined Patent Publication No. 257720/2002 *(Tokukai* 2002-257720)(Publication date: September 11, 2002), Japanese Unexamined Patent Publication No. 6834/ 1999 *(Tokukaihei* 11-6834)(Publication date: January 12, 1999), or Japanese Unexamined Patent Publication No. 267834/1998 *(Tokukaihei* 10-267834)(Publication date: October 9, 1998) discloses a production method of a surface plasmon resonance sensor chip.

However, a gold thin film formed by vapor deposition has an excessively uneven surface. Particularly, in the SPR, even when ligand is fixed in accordance with unevenness of the gold thin film surface on which the ligand is to be fixed, it may be impossible to obtain highly reproducible data, so that this hinders the study on this field.

Further, in order to form a gold thin film having a flatter surface, the deposition method itself is improved (e.g., sputtering or a similar method is adopted). However, it takes cost to improve the vapor deposition method. This results in such a problem that the price of each gold thin film becomes far from a practical price.

### DISCLOSURE OF INVENTION

The present invention was made in view of the foregoing problems, and an object of the present invention is to provide a metallic thin film chip producing apparatus and a metallic thin film chip producing method whereby it is possible to flatten an excessively uneven surface of a metallic thin film at lower cost.

In order to solve the foregoing problems, a metallic thin film producing apparatus according to the present invention flattens a surface of a metallic thin film formed on a first insulating substrate, and the metallic thin film chip producing apparatus includes: a placement table on which a metallic thin film chip is placed; pressing means for causing a second insulating substrate to sandwich and press the metallic thin film of the metallic thin film chip, placed on the placement table, in a vertical direction with respect to the surface of the metallic thin film; and heating means for heating the metallic thin film of the metallic thin film chip placed on the placement table.

Further, it is preferable to arrange the metallic thin film chip producing apparatus so that the heating means includes magnetic flux generation means for generating a magnetic flux penetrating the metallic thin film of the metallic thin film chip placed on the placement table, and the magnetic flux causes the metallic thin film to be heated.

Further, it is preferable to arrange the metallic thin film chip producing apparatus so that the heating means is a high frequency induction heater which includes a coil serving as the magnetic flux generation means.

According to the foregoing arrangement, the metallic thin film of the metallic thin film chip placed on the placement table and pressed is heated by the heating means. The heating means generates the magnetic flux. In case where the heating means is the high frequency induction heater which includes the coil, the coil of the high frequency induction heater generates a magnetic flux upon applying an alternating current. In the metallic thin film chip producing apparatus according to the present invention, the magnetic flux generated by the magnetic flux generation means penetrates the metallic thin film of the metallic thin film chip placed on the placement table. When the magnetic flux penetrates the metallic thin film in this manner, an eddy current is induced in the metallic thin film due to electromagnetic induction. The metallic thin film is heated to its fusing point or the vicinity of the fusing point by the eddy current.

The surface of the metallic thin film heated to the fusing point or the vicinity of the fusing point as described above becomes soft. The metallic thin film is sandwiched and pressed by the first insulating substrate and the second insulating substrate, so that a surface profile of the second insulating substrate (the surface is in contact with the metallic thin film) is transcribed onto the surface of the metallic thin film.

As described above, it is possible to transcribe the surface profile of the second insulating substrate onto the metallic thin film of the metallic thin film chip. By using the second insulating substrate which has a surface being in contact with the metallic thin film so that roughness of the surface (surface unevenness) is lower than the surface roughness of the metallic thin film, it is possible to improve the surface roughness of the metallic thin film.

Thus, the metallic thin film chip flattened by the metallic thin film chip producing apparatus according to the present invention can be more easily produced than a metallic thin film chip produced by high level vapor deposition, and it takes less cost to produce the metallic thin film chip according to the present invention than the metallic thin film chip produced by high level vapor deposition.

Further, in the metallic thin film chip producing apparatus according to the present invention, it is possible to heat the metallic thin film of the metallic thin film chip rapidly, so that it is possible to realize the metallic thin film chip producing apparatus which can be easily automated.

Further, it is preferable to arrange the metallic thin film chip producing apparatus according to the present invention so that the heating means heats the metallic thin film of the metallic thin film chip by irradiation of a microwave. Furthermore, it is preferable to arrange the metallic thin film chip producing apparatus according to the present invention so that the heating means is a dielectric heater which includes microwave generation means for generating the microwave irradiated to the metallic thin film of the metallic thin film chip.

According to the foregoing arrangement, the microwave generation means irradiates the microwave to the metallic thin film of the metallic thin film chip. Thus, oscillation of free electrons becomes active in the vicinity of the surface of the metallic thin film. The metallic thin film is heated to its fusing point or the vicinity of the fusing point, so that the metallic thin film is likely to be semi-liquid. Further, the pressing means presses the metallic thin film, so that it is possible to improve the surface roughness of the metallic thin film.

It is preferable to arrange the metallic thin film chip producing apparatus according to the present invention so that each of the placement table and the pressing means is made of a material whose dielectric loss is small.

On this account, even when the magnetic flux penetrates the placement table or the pressing means, the eddy current is not induced, so that neither the placement table nor the pressing means is heated. Thus, in the metallic thin film chip producing apparatus, it is possible to heat only the metallic thin film, so that it is possible to prevent the placement table and the pressing means from being heated, thereby preventing deformation of the placement table and the pressing :means.

Further, the heating means gives the following effect: in case of heating the metallic thin film of the metallic thin film chip by irradiating the microwave, each of the placement table and the pressing means made of a material whose dielectric loss is small allows a larger quantity of the microwave to pass therethrough, so that the placement table and the pressing means are not heated by the microwave irradiation, and heat conduction does not heat the first insulating substrate and the second insulating substrate for transcription.

It is preferable to arrange the metallic thin film chip producing apparatus according to the present invention so as to include a chamber for sealing up the metallic thin film chip placed on the placement table in vacuum or in an inert gas atmosphere.

On this account, it is possible to prevent oxidization of the metallic thin film of the metallic thin film chip, so that it is possible to prevent the surface quality of the metallic thin film from being deteriorated.

It is preferable to arrange the metallic thin film chip producing apparatus according to the present invention so as to include a chamber for shutting the metallic thin film chip placed on the placement table in a same atmosphere as a room air.

According to the foregoing arrangement, it is possible to prevent the oxidization of the surface of the metallic thin film since the microwave has a reducing property. Thus, according to the foregoing arrangement, it is possible to obtain such an effect that a trouble such as deaeration or inert gas exchange carried out in a room can be avoided unlike a case where there is provided a chamber for sealing up the metallic thin film chip in vacuum or an inert gas atmosphere.

Further, it is preferable to arrange the metallic thin film chip producing apparatus according to the present invention so as to include fixation means for fixing the metallic thin film of the metallic thin film chip with the metallic thin film sandwiched by the second insulating substrate.

On this account, it is possible to prevent the metallic thin film chip and the second insulating substrate from deviating from each other.

It is preferable to arrange the metallic thin film chip producing apparatus according to the present invention so that each of the placement table and the pressing means has a property which allows the microwave to pass therethrough.

According to the foregoing arrangement, each of the placement table and the pressing means has a property which allows the microwave to pass therethrough, so that a large quantity of the microwave generated by the microwave generation means passes through the placement table and the pressing means and reaches the metallic thin film. As a result, the heating efficiency of the metallic thin film is improved.

Further, it is preferable to arrange the metallic thin film chip producing apparatus so that the metallic thin film is made of gold.

On this account, in case where the metallic thin film chip producing apparatus according to the present invention is used to flatten the gold deposited film surface of the gold deposited chip used to carry out detection in SPR, it is possible to provide the gold deposited chip whose surface is favorably flattened at low cost.

Further, it is preferable to arrange the metallic thin film chip producing apparatus according to the present invention so that the second insulating substrate has a surface which is in contact with the metallic thin film so that roughness of the surface is 1 nm or less.

On this account, it is possible to transcribe the second insulating substrate's surface roughness profile of 1 nm or less onto the metallic thin film of the metallic thin film chip. When the surface roughness of the metallic thin film is set to 1 nm or less, it is possible to carry out reproducible measurement also in SPR.

In order to solve the foregoing problems, a metallic thin film chip producing method according to the present invention is a method for flattening a surface of a metallic thin film formed on a first insulating substrate, and the method includes the steps of: (i) causing a second insulating substrate to sandwich and press the metallic thin film in a vertical direction with respect to the surface of the metallic thin film; and (ii) heating the metallic thin film.

Further, it is preferable to arrange the metallic thin film chip producing method according to the present invention so that magnetic flux generation means generates a magnetic flux penetrating the metallic thin film so as to heat the metallic thin film in the step (ii).

In the steps (i) and (ii), the metallic thin film is heated to its fusing point or the vicinity of the fusing point and the heated metallic thin film is pressed, so that it is possible to transcribe the surface profile of the second insulating substrate onto the surface of the metallic thin film. By selecting the second insulating substrate whose surface roughness is low, it is possible to flatten the surface of the metallic thin film.

Further, it is preferable to arrange the metallic thin film chip producing method according to the present invention so that microwave generation means irradiates a microwave to the metallic thin film so as to heat the metallic thin film in the step (ii) .

It is preferable to arrange the metallic thin film chip producing method according to the present invention so that the steps (i) and (ii) are carried out in vacuum or an inert gas atmosphere or in a same atmosphere as a room air.

On this account, it is possible to prevent oxidization of the metallic thin film of the metallic thin film chip, so that it is possible to prevent the surface of the metallic thin film from being deteriorated.

Further, it is preferable to arrange the metallic thin film chip producing method according to the present invention so that the metallic thin film is formed by vapor deposition.

For a fuller understanding of the nature and advantages of the invention, reference should be made to the ensuing detailed description taken in conjunction with the accompanying drawings.

### BRIEF DESCRIPTION OF DRAWINGS

Fig. 1(a) is a cross sectional view schematically illustrating a structure of a metallic thin film chip producing apparatus according to the present invention. Fig. 1(b) is a cross sectional view schematically illustrating a structure of the metallic thin film chip according to the present invention.
Fig. 2 is a surface roughness profile obtained by observing a predetermined straight line of a surface of a gold deposited film through AFM.
Fig. 3 is a surface roughness profile obtained by observing a predetermined straight line of a flattening glass substrate's surface, which is in contact with a surface of the metallic thin film, through AFM.
Fig. 4 is a surface roughness profile obtained by observing a predetermined straight line of a gold deposited film, which has been flattened by the metallic thin film chip producing apparatus according to the present invention, through AFM.
Fig. 5 is a surface roughness profile obtained by observing a predetermined straight line of a gold deposited film, which has not been flattened by the metallic thin film chip producing apparatus according to the present invention, through AFM.
Fig. 6(a) is a surface roughness profile obtained by observing a predetermined straight line of a gold deposited film, which has been kept at 500°C for 10 hours, through AFM. Fig. 6(b) is a surface roughness profile obtained by observing a predetermined straight line of a gold deposited film, which has been kept at 500°C for 30 hours, through AFM.
Fig. 7 is a surface roughness profile obtained by observing a surface of a gold deposited film, which has been experimented at a frequency of 2.45 GHz, an oscillation output of 950 W, a compressive load of 39.2 N (compressive stress of 0.30 MPa), for a microwave oscillation time of 5 minutes, through AFM.
Fig. 8 is a surface roughness profile obtained by observing a surface of a gold deposited film, which has been experimented at a frequency of 2.45 GHz, an oscillation output of 950 W, a compressive load of 39.2 N (compressive stress of 0.30 MPa), for a microwave oscillation time of 3 minutes, through AFM.

### BEST MODE FOR CARRYING OUT THE INVENTION

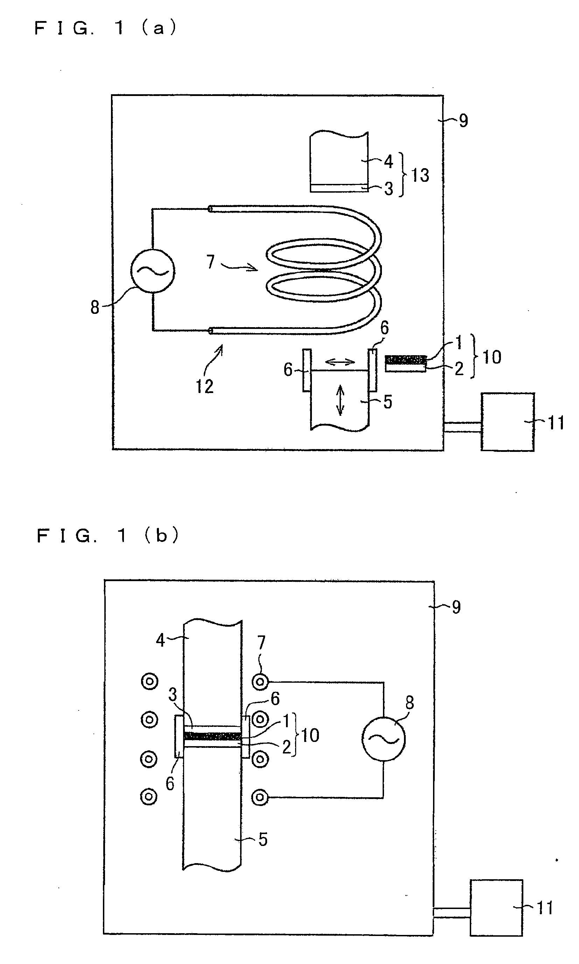

The following will explain one embodiment of a metallic thin film chip producing apparatus according to the present invention with reference to Figs. 1 through 6. Note that, the present invention is not limited to this.

Figs. 1 (a) and 1 (b) are cross sectional views each of which schematically illustrates the metallic thin film chip producing apparatus according to the present invention. As illustrated in Fig. 1 (a), the metallic thin film chip producing apparatus according to the present invention includes, in a vessel (chamber) 9, pressing means 13 having an insulating substrate 3 and a pressing member 4, a chip placement table 5, and a heater (heating means) 12 having a coil 7 and a power source 8 for supplying an alternating current to the coil (magnetic flux generation means) 7. On the vessel 9, a vacuum pump (air exhaustion means) 11 for exhausting air from the vessel 9 is provided.

In the metallic thin film chip producing apparatus, a metallic thin film chip 10 obtained by forming a metallic thin film 1 on an insulating substrate 2 (first insulating substrate) is placed on the chip placement table 5. As illustrated in Fig. 1(b), the metallic thin film chip 10 placed on the chip placement table 5 is sandwiched and pressed by the chip placement table 5 and the pressing means 13. At this time, the metallic thin film 1 of the metallic thin film chip 10 faces (is in contact with) the insulating substrate 3 of the pressing means 13. Note that, the metallic thin film 1 is sandwiched and pressed by the insulating substrate 2 and the insulating substrate 3.

Further, the thus pressed metallic thin film 1 of the metallic thin film chip 10 which is placed on the chip placement table 5 is heated by the heater 12. The heater 12 is described as follows. When an alternating current is supplied from the power source 8, the coil 7 of the heater 12 generates a magnetic flux. In the metallic thin film chip producing apparatus, the magnetic flux generated by the coil 7 penetrates the metallic thin film 1 of the metallic thin film chip 10 placed on the chip placement table 5. When the magnetic flux penetrates the metallic thin film 1 in this manner, an eddy current is induced in the metallic thin film 1 due to magnetic induction. The metallic thin film 1 is heated until the metallic thin film 1 reaches its fusing point due to the eddy current.

A surface of the metallic thin film 1 heated to the fusing point becomes soft. Further, the metallic thin film 1 is sandwiched and pressed by the insulating substrate 2 and the insulating substrate 3, so that a surface profile of the insulating substrate 3 which is in contact with the metallic thin film 1 is transcribed onto the surface of the metallic thin film 1.

As described above, it is possible to transcribe the surface profile of the insulating substrate 3 onto the metallic thin film 1 of the metallic thin film chip 10. As the insulating substrate 3, a substrate whose surface roughness (surface unevenness) which is in contact with the metallic thin film 1 is lower than surface roughness of the metallic thin film 1, thereby improving the surface roughness of the metallic thin film 1. In case where the metallic thin film 1 is formed by vapor deposition, its surface roughness is 5 nm, and the surface roughness of the insulating substrate 3 may be arbitrarily set as long as it is possible to improve the surface roughness of the metallic thin film 1. For example, the surface roughness of the insulating substrate 3 preferably ranges from 2 nm to 1 nm, more preferably is 1 nm or lower. If it is possible to set the surface roughness of the metallic thin film 1 to 1 nm or lower, it is possible to realize reproducible measurement also in the SPR. Further, it is possible to directly observe ligand, fixed on the surface, through AFM (atom force microscope) and the like.

Note that, each of the insulating substrate 2 and the insulating substrate 3 is made of insulating material. Thus, even if the magnetic flux penetrates them, no eddy current is induced, so that they are not heated. Therefore, in the metallic thin film chip producing apparatus, it is possible to heat only the metallic thin film 1, so that it is possible to prevent deformation caused by heat of the insulating substrate 2 and the insulating substrate 3.

Further, the vessel 9 is internally vacuumed by the vacuum pump 11, thereby preventing the metallic thin film 1 of the metallic thin film chip 10 from being deteriorated by oxidization or the like. Also, an inert gas exchanging device for infusing inert gas into the vessel 9 may be provided instead of the vacuum pump 11. This can prevent the metallic thin film 1 of the metallic thin film chip 10 from being deteriorated.

Further, a fixing member may be provided so that the metallic thin film chip 10 and the insulating substrate 3 are not deviated from each other. In the present embodiment, an example of the fixing member is a tape made of insulating material or a similar member, but the fixing member is not limited as long as the member is made of insulating material. Further, the pressing member 13 is constituted of the pressing member 4 and the insulating substrate 3 in the foregoing description, but it may be so arranged that the insulating substrate 3 is separately provided. In this case, the insulating substrate 3 is placed on the chip placement table 5 while being in closely contact with the metallic thin film chip 10 in advance, and is pressed by the pressing member 4.

The respective members are described as follows.

The metallic thin film chip 10 is not particularly limited as long as the chip is obtained by forming the metallic thin film 1, produced by a conventional thin film production method, on the insulating substrate 2. An example of the chip is an inexpensive chip obtained by forming the metallic thin film 1 on the insulating substrate 2 by vapor deposition or sputtering.

A material of each of the insulating substrate 2 and the insulating substrate 3 is not particularly limited as long as the material is an insulating material, but it is preferable to use a material which is hardly softened by heat generated when the coil 7 heats the metallic thin film 1. On this account, the insulating substrate 2 and the insulating substrate 3 are not deformed in pressing and heating the metallic thin film 1. Thus, in flattening the surface of the metallic thin film 1, it is possible to exactly transcribe the surface unevenness of the insulating substrate 2 or the insulating substrate 3 onto the surface of the metallic thin film 1 of the metallic thin film chip 10, so that it is possible to provide the metallic thin film chip producing apparatus which can more evenly flatten the surface of the metallic thin film.

Furthermore, in case of flattening the gold deposited film used in the SPR, it is preferable to use a glass material as the material of the insulating substrate 2 or the insulating substrate 3.

A material of the pressing member 4 and the chip placement table 5 is not particularly limited as long as each material is an insulating material, but it is preferable to use quartz glass or ceramic. This is based on the following reason. The material is in contact with the insulating substrate 2 or the insulating substrate 3, so that heat of the coil 7 raises temperature of the insulating substrate 2 or the insulating substrate 3, which may result in deformation of the insulating substrate 2 or the insulating substrate 3 upon being pressed. Particularly, as the material of the pressing member 4 and the chip placement table 5, it is preferable to use a material whose dielectric loss is small.

In the present embodiment, the metallic thin film 1 of the metallic thin film chip 10 is heated to its fusing point of the metallic thin film 1, but the arrangement of the present invention is not limited to this. The metallic thin film 1 may be heated at temperature which allows the metallic thin film 1 to be softened. The temperature at which the metallic thin film 1 is heated is influenced by a frequency of the alternating current supplied from the power source 8 to the coil 7. As the frequency of the alternating current is higher, the magnetic flux generated by the coil 7 has higher density. The high density magnetic flux penetrates the metallic thin film 1 of the metallic thin film chip 10, so that a high density eddy current occurs in the metallic thin film 1. As a result, it is possible to heat the metallic thin film 1 of the metallic thin film chip 10 to its fusing point or the vicinity of the fusing point in a shorter time. The heating time varies in relation to the temperature rise of the insulating substrate 2 and the insulating substrate 3. As the heating time is longer, the temperature further rises. Thus, it is preferable that the heating time is shorter in consideration for deformation of the insulating substrate 2 and the insulating substrate 3. Therefore, it is preferable to set the frequency of the alternating current to several KHz to several MHz in heating the metallic thin film 1 in a short time. The heat generated in the metallic thin film 1 due to the eddy current varies depending on resistivity and permeability of the material of the metallic thin film 1, so that it is possible to suitably set the frequency of the alternating current in accordance with the material of the metallic thin film 1 of the metallic thin film chip 10.

The heating time of the metallic thin film 1 of the metallic thin film chip 10, that is, the time in which the alternating current is supplied to the coil 7 is influenced by the heating temperature, so that it is possible to suitably set the heating time in accordance with the material of the metallic thin film 1 of the metallic thin film chip 10.

As to a pressure load exerted by the pressing member 4 and the placement table 5, in case where the metallic thin film 1 is heated to its fusing point, it is possible to transcribe the surface unevenness of the insulating substrate 3 onto the metallic thin film 1 at about 0.1 to 10 MPa. Thus, the pressure load ranging from 0.1 to 10 MPa is preferable. Note that, the pressure load is not particularly limited as long as the pressure load does not damage the insulating substrate 2 and the insulating substrate 3. Under this condition, the pressure load can be suitably set in accordance with the heating time and the heating temperature of the metallic thin film 1, a metal type of the metallic thin film 1, and an area size of the metallic thin film surface of the metallic thin film chip 10.

Further, in the metallic thin film chip producing apparatus illustrated in Fig. 1, the metallic thin film 1 of the metallic thin film chip 10 placed on the placement table 5 is sandwiched and pressed in a vertical direction by the insulating substrate 3, but the arrangement may be varied as long as the metallic thin film 1 is sandwiched in a vertical direction with respect to the surface of the metallic thin film 1. For example, the metallic thin film chip producing apparatus may be arranged so that: a direction in which the pressing member 4 exerts a pressure load is regarded as an upward direction, and the metallic thin film is sandwiched in a horizontal direction (a direction vertical to the upward direction).

Next, the following will explain an example of a production method of the metallic thin film chip produced by the metallic thin film chip producing apparatus according to the present invention.

First, the metallic thin film chip 10 is prepared by forming the metallic thin film 1 on the insulating substrate 2. Next, the metallic thin film 1 of the metallic thin film chip 10 is sandwiched and pressed by the insulating substrate 3 of the pressing means from a vertically upward direction of the metallic thin film 1 (step (i)).

Further, the coil 7 of the heating means causes the magnetic flux to penetrate the metallic thin film 1 so as to heat the metallic thin film 1 (step (ii)). At this time, the vessel 9 may be internally vacuumed or an inert gas atmosphere is introduced into the vessel 9. It is possible to generate the magnetic flux by supplying the alternating current from the power source 8 to the coil 7.

In the steps (i) and (ii), the metallic thin film 1 is heated to its fusing point or the vicinity of the fusing point and the heated metallic thin film 1 is pressed, thereby transcribing the surface profile of the insulating substrate 3 onto the surface of the metallic thin film 1. By selecting the insulating substrate 3 whose surface roughness is small, it is possible to flatten the surface of the metallic thin film 1.

As described above, in the metallic thin film chip producing apparatus according to the present invention and the method according to the present invention for producing the metallic thin film chip, the metallic thin film of the metallic thin film chip obtained through simple and inexpensive vapor deposition is heated by the coil in a short time while being pressed by the pressing means, so that it cost much less to carry out these steps than the case where high level vapor deposition is adopted. Moreover, it is possible to rapidly heat the metallic thin film of the metallic thin film chip, so that it is easy to automate the steps.

In case where the metallic thin film chip producing apparatus according to the present invention and the method according to the present invention for producing the metallic thin film chip are applied particularly to the gold deposited chip used in the SPR, it is possible to promptly obtain gold deposited chips, each having a flat gold deposited film surface, in large quantity. Thus, it is possible to realize the low cost which allows daily use of the gold deposited chip in the SPR, so that it is possible to obtain reproducible data.

In the present invention, the heating means is not particularly limited as long as it is possible to heat the metallic thin film of the metallic thin film chip placed on the placement table. For example, the heating means may include microwave generation means for generating a microwave. The heating means heats the metallic thin film by irradiating the microwave to the metallic thin film of the metallic thin film chip.

In case where the microwave is irradiated to a metallic thin film whose thickness is relatively large (ranges from several µm to several mm), free electrons are more actively oscillated in the vicinity of the surface of the metallic thin film, so that the metallic thin film is heated. However, with the activation of the free electron oscillation, a subsequent microwave cannot enter the metallic thin film, so that the microwave is likely to be reflected by the surface of the metallic thin film (shielding effect). Furthermore, when the oscillation of free electrons in the vicinity of the surface is excessively active, some free electrons fly out or jump to another substance (so-called electrical discharge). Thus, the microwave irradiation has rarely been used as a method for heating metal.

However, in case of a metallic thin film whose thickness is extremely thin (nm order), such as the gold deposited chip, which can be applied to the metallic thin film chip producing apparatus of the present invention, the whole metallic thin film can be regarded as the vicinity of the surface. Therefore, by suitably adjusting a quantity of the supplied microwave to be irradiated, it is possible to heat the metallic thin film to its fusing point or the vicinity of the fusing point or until the metallic thin film becomes semi-liquid.

Further, also in case of the metallic thin film whose thickness is extremely thin, when the oscillation of free electrons in the vicinity of the surface is excessively active, some free electrons fly out or jump to another substance (so-called electrical discharge). However, in the metallic thin film chip producing apparatus of the present invention, the pressing means causes the metallic thin film of the metallic thin film chip placed on the placement table to be sandwiched and pressed by the second insulating substrate in a direction vertical to the surface of the metallic thin film. Thus, the metallic thin film is closely sandwiched between the placement table and the second insulating substrate. Therefore, free electrons hardly fly out, so that it is possible to suppress the electric discharge.

Further, it is preferable that each of the pressing means and the replacement table is made of material whose dielectric loss is small. In case where the dielectric loss is large, less microwave passes through the material. In addition, irradiation of the microwave heats the first insulating substrate and the second insulating substrate for transcription due to heat conduction. Thus, it is not preferable to use the material whose dielectric loss is large. In case of using the material whose dielectric loss is small, the pressing means and the placement table are hardly heated by the microwave. Further, it is preferable that the pressing means and the placement table allow the microwave to pass therethrough. On this account, a large part of the microwave generated by the microwave generation means passes through the replacement table and the pressing means, and then reaches the metallic thin film. Therefore, it is possible to obtain such an effect that a heating efficiency of the metallic thin film is improved.

An example of the material which allows the microwave to pass therethrough includes a polymer material such as pyrex (registered trademark) glass, quartz glass, silicon resin, polystyrene, polypropyrene, and fluorine. In case of using the polymer material such as silicon resin, polystyrene, polypropyrene, and fluorine, particularly in case of arranging the metallic thin film chip producing apparatus so that the metallic thin film is sandwiched from a horizontal direction (a direction vertical to the upward direction), the material can be favorably used.

Among them, it is preferable to use the pyrex (registered trademark) glass since the pyrex (registered trademark) glass allows a large part of the microwave to pass therethrough and its dielectric loss is small. The microwave is partially absorbed. However, the dielectric loss of the pyrex (registered trademark) glass is large, so that the irradiation of the microwave does not raise the temperature. Therefore, a large part of the irradiated microwave penetrates the pressing means and the placement table each of which is made of pyrex (registered trademark) glass, and reaches the surface of the metallic thin film. Note that, the pyrex (registered trademark) glass is used as a vessel used in a home electronic oven.

The dielectric loss of the quartz glass is smaller than that of the pyrex (registered trademark) glass, and it is possible to greatly suppress heat generation of the pressing means and the placement table. Thus, it is more preferable to use the quartz glass.

Further, it is preferable to arrange the metallic thin film chip producing apparatus according to the present invention so as to include a chamber for shutting the metallic thin film chip placed on the placement table in the same atmosphere as a room air in case of heating the metallic thin film chip by microwave irradiation.

In case of heating with the high frequency induction heater, when the atmosphere has oxygen, the surface of the metallic thin film is likely to be oxidized. Therefore, in case of heating with the high frequency induction heater, it is preferable to heat the metallic thin film in vacuum or an inert gas. However, in case of heating through the microwave irradiation, the microwave has a reducing property, so that it is possible to heat in an atmosphere having oxygen. Therefore, unlike the case where there is provided the chamber for shutting the metallic thin film chip in vacuum or in an inert gas atmosphere, it is possible to obtain such an effect that a trouble such as deaeration or inert gas exchange carried out in a room can be avoided. In this case, it is necessary to provide a chamber for blocking the microwave so that the microwave does not leak to the outside.

Further, in the microwave generation means, an oscillation frequency, an oscillation output, or an oscillation time of the microwave, or a pressure load exerted by the pressing means can be suitably set in accordance with a size of the metallic thin film, a type of the insulating material, a placement point of the metallic thin film chip, or a spatial structure of the chamber, etc. Qualitatively, in case of increasing the oscillation frequency and the oscillation output of the microwave, the oscillation time may be short.

For example, in case where the gold deposited chip is applied as the metallic thin film chip, it is preferable to set the oscillation frequency of the microwave to 2.45 to 100 GHz, and it is preferable to set the oscillation output to 0.1 to 2 kW, and it is preferable to set the oscillation time to 0.1 to 10 minutes.

The oscillation frequency of 2.45 GHz is a frequency whose maximum acceptable radiation value is free from any limit as an ISM frequency band, and is open so as to be applied to various industrial, scientific, medical, or home tools or devices. Currently, an industrial oscillator whose frequency is higher than that frequency is being developed. This oscillator is referred to as "gyrotron". An example of the oscillator is an oscillator whose oscillation frequency is 28 GHz or an oscillator whose oscillation frequency is 100 GHz. However, the oscillator having such a high oscillation frequency is expensive, and it is practical to adopt an oscillation frequency of 5.8 GHz or lower. Thus, it is particularly preferable that the frequency of the microwave applicable to the present invention ranges from 2.45 to 5.8 GHz.

Further, as will be described in Examples, when the metallic thin film was heated at an oscillation output of 950 W, the metallic thin film became semi-liquid by 5-minute microwave irradiation. While, when 3-minute microwave irradiation was carried out, the heating temperature was low. When the oscillation output was decreased so as to be less than 950 W, it took some time (several ten minutes) for the metallic thin film to be semi-liquid. Therefore, the microwave oscillation output can be suitably set in accordance with a size of the metallic thin film, a type of the insulating material, a placement point of the metallic thin film chip, a spatial structure of the chamber, etc., but it is preferable that the oscillation output ranges from 0.1 to 2 kW. Note that, the oscillation output is an oscillation output for a single metallic thin film chip. In case of simultaneously heating several metallic thin film chips, it is necessary to use an oscillation output obtained by multiplying the foregoing oscillation output by the number of the metallic thin film chips. Some industrial large scale oscillators can realize 90 kW.

Further, the oscillation time can be suitably set in accordance with the oscillation frequency or the oscillation output of the microwave or other various conditions, but it is preferable to set the oscillation time to 0.1 to 10 minutes.

In addition, the compressive load exerted by the pressing means can be suitably set in accordance with the strength of the metallic thin film. In case where the metallic thin film is so soft that the metallic thin film is likely to be deformed, the compressive load may be decreased. Further, in case where the temperature is so low that the metallic thin film is hard to deform, it is necessary to exert a higher compressive load. As will be described in Examples, in case of heating through the microwave irradiation, the metallic thin film was heated to the vicinity of its fusing point, so that the metallic thin film became semi-liquid. Thus, by exerting the compressive load of 0.30 MPa, the surface profile of the second insulating substrate was transcribed. Therefore, in case where the metallic thin film is completely fused as liquid, the compressive load may be low. However, in case of exerting the low compressive load after changing the metallic thin film into liquid, the metal may leak out. Further, in case of exerting a higher compressive load (in case where the compressive load is higher than 10 MPa), the second insulating substrate may be damaged. Therefore, it is preferable that the compressive load exerted by the pressing means ranges from 0.1 to 10 MPa.

More specifically, the microwave oscillation frequency is set to 2.45 GHz, the oscillation output is set to 950 W, the oscillation time is set to 5 minutes, and the compressive load exerted by the pressing means is set to 0.30 MPa, thereby flattening the gold deposited film of the gold deposited chip.

As described above, the metallic thin film is heated with the microwave so as to keep a condition under which the metallic thin film is likely to be deformed like a semi-liquid condition, so that the pressing means can deform the surface of the metallic thin film with a less compressive load (compressive stress). Therefore, it is possible to more easily transcribe the surface profile of the second insulating substrate onto the surface of the metallic thin film.

Further, a circumstance in which the metallic thin film is pressed and heated through the microwave irradiation heating is not particularly limited. The microwave irradiation heating may be carried out in a room air, an inert gas, or vacuum.

As described above, a metallic thin film chip producing apparatus according to the present invention includes: a placement table on which a metallic thin film chip is placed; pressing means for causing a second insulating substrate to sandwich and press the metallic thin film of the metallic thin film chip, placed on the placement table, in a vertical direction with respect to the surface of the metallic thin film; and heating means for heating the metallic thin film of the metallic thin film chip placed on the placement table, wherein the heating means includes magnetic flux generation means for generating a magnetic flux penetrating the metallic thin film of the metallic thin film chip placed on the placement table, and the magnetic flux causes the metallic thin film to be heated, or the heating means heats the metallic thin film of the metallic thin film chip by irradiation of a microwave.

On this account, it is possible to heat the metallic thin film to its fusing point or to the vicinity of the fusing point, so that it is possible to easily transcribe the surface profile of the second insulating substrate, being in contact with the metallic thin film, onto the surface of the metallic thin film. Therefore, the pressure exerted by the pressing means to the metallic thin film allows improvement of the surface roughness of the metallic thin film, thereby easily flattening the metallic thin film chip.

The following Examples will detail preferable modes of the present invention, but these Examples are mere references to explain the present invention, so that the present invention is not limited to them. Person with ordinary skill in the art can change, modify, and vary these Examples so as not to depart from the scope of the present invention.

The following Example is given by illustrating a gold deposited chip, obtained by depositing gold on a glass substrate (corresponding to the insulating substrate 2) by vapor deposition or sputtering, as a metallic thin film chip 10. The gold deposited film corresponds to the metallic thin film 1.

### [Example 1: Measurement of the thickness of the gold deposited film]

In the present Example, the thickness of the gold deposited film of the gold deposited chip was measured.

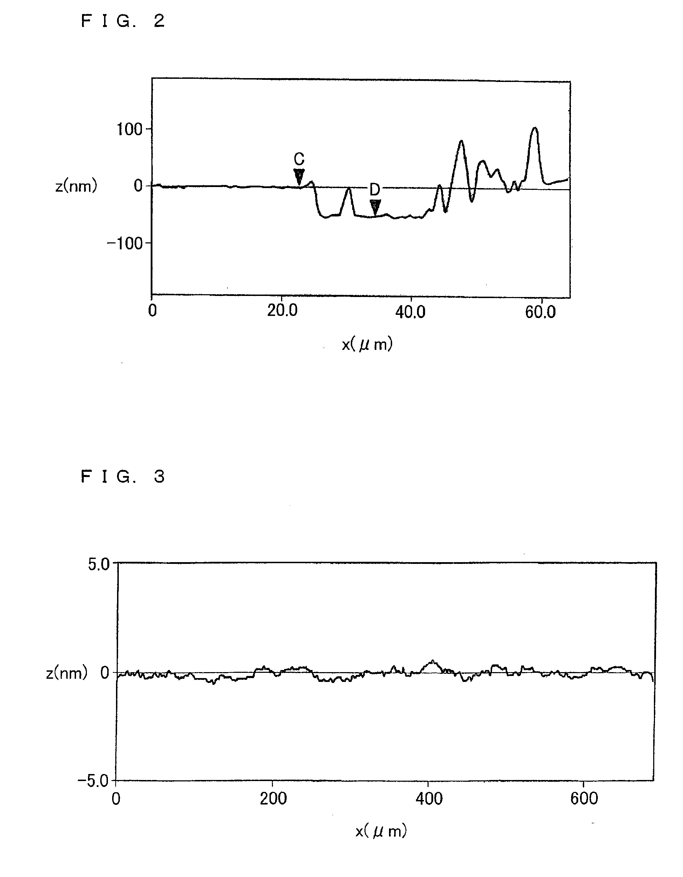

A surface of the gold deposited film of the gold deposited chip was scratched with tweezers so that the glass substrate was exposed, and the surface of the gold deposited film was observed by an atom force microscope (AFM). Fig. 2 illustrates a surface roughness profile obtained by observing a predetermined straight line of the surface of the gold deposited film by AFM. A point C on the surface of the gold deposited film indicates a surface shape which had not been scratched by the tweezers. Further, a point D indicates a surface shape in which the insulating substrate 2 was exposed by scratching the surface with the tweezers. Note that, in Fig. 2, x indicates a direction of the predetermined straight line of the surface of the gold deposited film, and y indicates a vertical direction under such condition that the surface of the gold deposited film in the straight line was flat.

As indicated by the surface profile of Fig. 2, a distinct difference between the point C and the point D of the surface of the gold deposited film is found. A vertical distance between the point C and the point D was measured. As a result of the measurement, the vertical distance was about 50 nm. The point D was the position in which the glass substrate was exposed, so that the thickness of the gold deposited film was 50 nm.

### [Example 2: Measurement of surface roughness of a flattening glass substrate]

In the metallic thin film producing apparatus according to the present invention, a flattening glass substrate used as the insulating substrate 3 had a surface which was in contact with the surface of the metallic thin film of the metallic thin film chip. The surface roughness was measured.

In the flattening glass substrate, the surface which was in contact with the surface of the metallic thin film 1 of the metallic thin film chip 10 was observed by AFM. Fig. 3 illustrates a surface roughness profile obtained by observing a predetermined straight line of the surface of the flattening glass substrate which surface was in contact with the surface of the metallic thin film 1. Note that, in Fig. 3, x indicates a direction of the predetermined straight line of the flattening glass substrate's surface which is in contact with the surface of the metallic thin film 1, and z indicates a vertical direction under such condition that the surface of the flattening glass substrate was flat.

The surface roughness of Fig. 3 shows that a surface roughness value of the flattening glass substrate is 1 nm. Note that, the surface roughness value corresponds to a height difference between a peak and a trough adjacent to each other in the surface roughness profile. Thus, as the surface roughness value is larger, the surface is more uneven.

### [Example 3: Flattening of the gold deposited film by the metallic thin film chip producing apparatus according to the present invention]

The gold deposited film was flattened by using the metallic thin film chip producing apparatus. As illustrated in Example 1, the thickness of the gold deposited film was 50 nm. Further, an area size of the gold deposited film was 3 mm × 5 mm = 15 mm². Note that, the flattening glass substrate used in Example 2 was used as the insulating substrate 3.

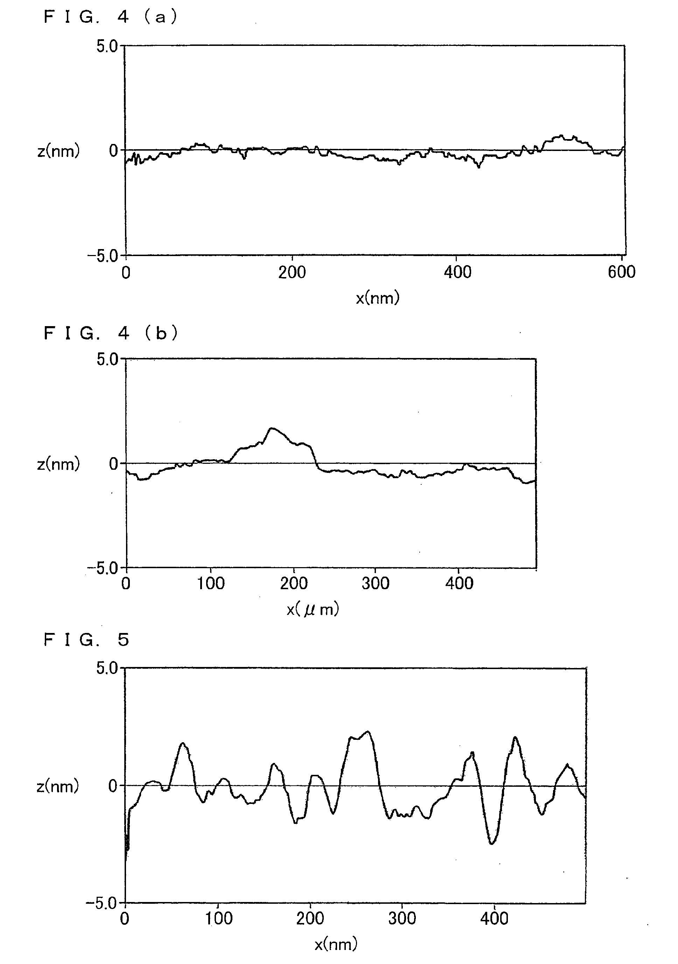

First, a surface of the gold deposited film was observed through AFM. Fig. 5 illustrates a surface roughness profile obtained by observing a predetermined straight line of the surface of the gold deposited film by AFM. Note that, in Fig. 5, x indicates a direction of the predetermined straight line of a surface on which gold was deposited, and z indicates a vertical direction under such condition that the surface of the gold deposited film in the straight line was flat. The surface roughness profile of Fig. 5 shows that a surface roughness value of the gold deposited film was 5 nm.

Further, in the present example, quartz glass materials were used as the pressing member 4 and the chip placement table 5 so as to flatten the gold deposited film. Note that, a compressive load exerted by the pressing member 4 to the gold deposited film was set to be a compressive stress of 1 MPa. The inside of the vessel 9 was made vacuum, and an alternating current of 1.7 KHz was supplied to the coil 7, and the gold deposited film was heated for 30 seconds. Further, in the present example, the gold deposited chip and the flattening glass substrate were fixed with a scotch tape as a fixing member so as not to be deviated from each other.

After heating, no change was found in the scotch tape, and it was found that the scotch tape was not heated. Further, the glass substrate of the gold deposited chip allowed direct touch with hands. This means that only the gold deposited film was heated by the coil 7. Also, this means that an eddy current generated in the coil 7 resulted in a smaller total heat value of the gold deposited film.

The surface of the gold deposited film subjected to the foregoing treatment was observed by AFM. Each of Figs. 4(a) and 4(b) illustrates a surface roughness profile obtained by observing a predetermined straight line of the surface of the gold deposited film by AFM. Note that, in Figs. 4(a) and 4(b), x indicates a direction of a predetermined straight line of the surface of the gold deposited film, and z indicates a vertical direction under such condition that the gold deposited film was flat.

As illustrated in Fig. 4(a), a surface roughness value of the gold deposited film treated by the metallic thin film chip producing apparatus according to the present invention was 1 nm. The surface roughness value is equal to the surface roughness value of the glass substrate used in Example 2. This shows that the glass surface profile of the glass substrate was transcribed onto the surface of the gold deposited film. Thus, it was found that the surface profile of the gold deposited film was transformed into a flat surface.

As illustrated in Fig. 4(b), an excessively uneven portion was found in the surface of the gold deposited film. The surface roughness value of the portion was 2 nm. This may be based on the following reason: The compressive load exerted to the surface of the gold deposited film of the gold deposited chip at the time of the transcription was insufficient, so that the surface of the flattening glass substrate was not sufficiently filled with gold. Thus, the surface roughness can be improved by increasing the compressive load.

### [Comparative Example 1]

The inventors of the present invention studied also a method in which a gold deposited insulating substrate was heated without being pressed and aggregation of gold deposited particles on the insulating substrate was promoted so as to flatten the uneven surface of the gold deposited film. When the insulating substrate was heated at a temperature exceeding a recrystallization temperature of gold (in the vicinity of 200°C), the gold deposited particles grew through aggregation by utilizing surface energy as a driving force, so that the gold deposited film became flat. However, when the heating temperature is high, the insulating substrate becomes soft. This does not allow the gold deposited film to be flattened. Thus, it is necessary to set the heating temperature to a temperature lower than 500°C (softening point of glass). Thus, the inventors carried out a method in which the gold deposited film was grown through aggregation in setting the heating temperature to 500°C.

In vacuum, the gold deposited chip was heated to 500°C at a rate of 100°C/h. Further, after heating the gold deposited chip, the gold deposited chip was kept at 500°C for 10 hours or 30 hours, and then the gold deposited chip was cooled to a room temperature at a rate of 100°C/h.

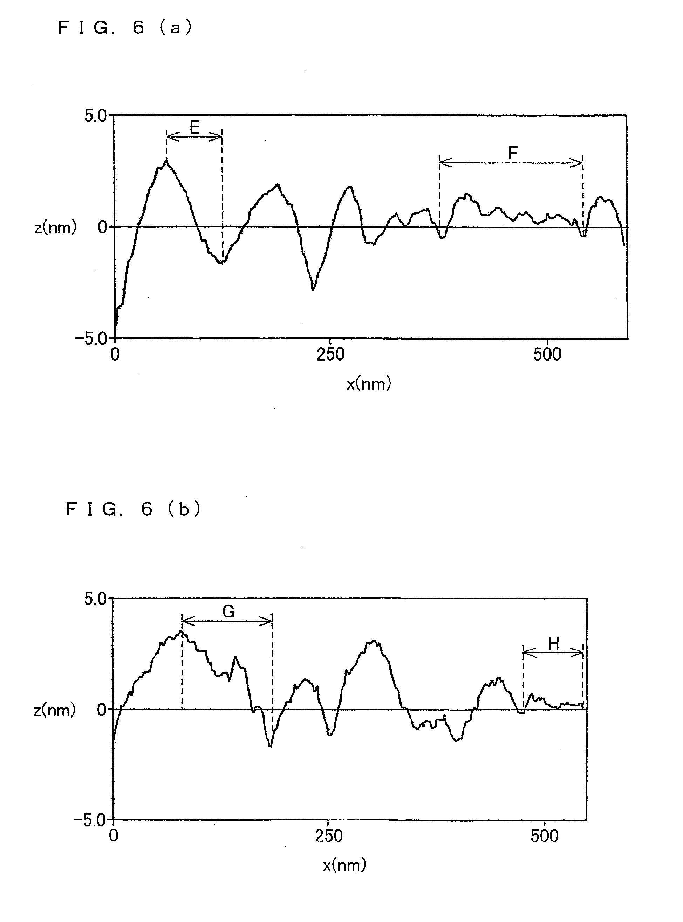

A surface of the cold deposited film was observed by AFM. Each of Figs. 6(a) and 6(b) illustrates a surface roughness profile obtained by observing a predetermined straight line of the surface of the gold deposited film through AFM. Note that, in Figs. 6(a) and 6(b), x indicates a direction of the predetermined straight line of the surface of the gold deposited film, and z indicates a vertical direction under such condition that the surface of the gold deposited film was flat. Fig. 6(a) illustrates a surface roughness profile of the gold deposited film kept at 500°C for 10 hours, and Fig. 6(b) illustrates a surface roughness profile of the gold deposited film kept at 500°C for 30 minutes.

As illustrated in Figs. 6(a) and 6(b), a surface roughness value of an aggregated portion (a surface area of F in Fig. 6(a) and a surface region of H in Fig. 6(b)) was 2 nm. While, a surface roughness value of a portion which had not been aggregated (a surface region of E in Fig. 6(a) and a surface region of G in Fig. 6(b)) was 5 nm. As a result, it was found that the gold deposited particles were aggregated when the gold deposited film grew through aggregation by setting the heating temperature to 500°C. In case where the gold deposited film was kept for 30 hours, aggregation of the gold deposited particles was further promoted than a case where the gold deposited film was kept for 10 hours. However, also in the case where the gold deposited film was kept for 30 hours, the aggregation locally occurred, and some portions were not aggregated. It is expected that the surface roughness of the gold deposited film will be entirely even (the surface roughness value will be 2 nm) in case where the gold deposited film is kept for longer time. However, only the surface energy was used as a driving force to flatten the uneven surface of the gold deposited film, so that a rate at which the gold deposited particles were aggregated was low, which resulted in higher cost.

### [Example 4]

The metallic thin film chip producing apparatus of the present invention was used to flatten the gold deposited film. An area size of the gold deposited film was 13 mm × 10 mm = 130 mm².

The gold deposited film was sandwiched by a flattening glass substrate (second insulating substrate) whose surface roughness was 1 nm or less, and a compressive load was vertically exerted to the gold deposited film. Note that, as a compressive-load poise (pressing means), a pyrex (registered trademark) glass plate was used. Further, adjustment for increasing/decreasing the compressive load was carried out by changing the number of pyrex (registered trademark) glass plates.

In a room air, a microwave is irradiated to the gold deposited film, thereby flattening the gold deposited film. The microwave generation means had a frequency of 2.45 GHz and an oscillation output of 950 W (commercial microwave oven). Further, temperature adjustment for flattening the gold deposited film was carried out by changing a microwave oscillation time.

After flattening the gold deposited film, the surface of the gold deposited film was observed by AFM.

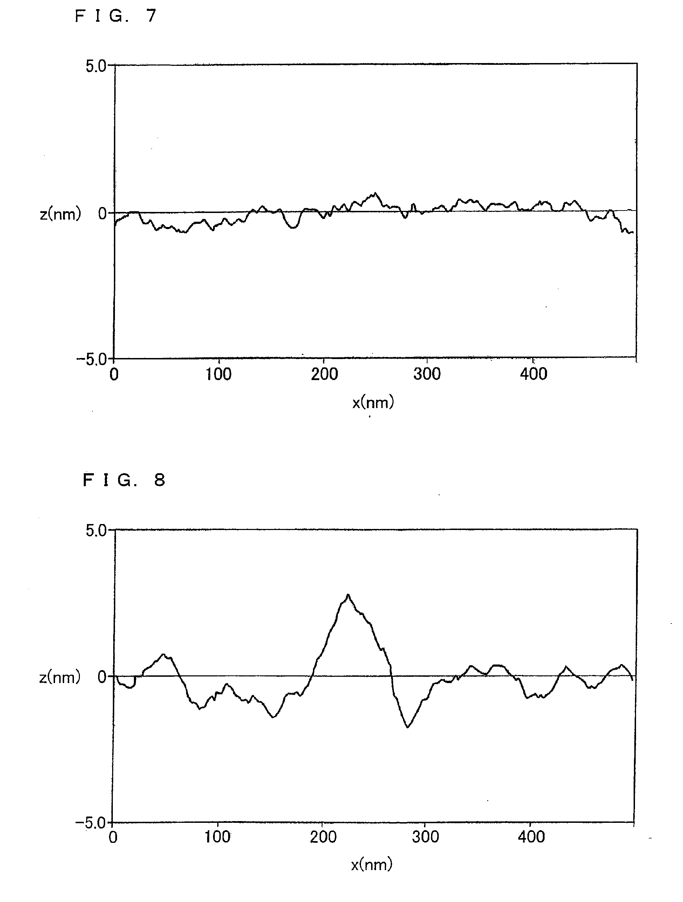

In the present example, an experiment was carried out under such condition that the compressive load was 39.2 N (compressive stress was 0.30 MPa) and the microwave oscillation time was 5 minutes. Under this condition, the surface of the gold deposited film was observed by AFM. A surface profile obtained by observing the surface of the gold deposited film is illustrated in Fig. 7. As illustrated in Fig. 7, the surface roughness of the gold deposited film was about 1 nm. It was found that the surface unevenness of the flattening glass substrate was transcribed.

### [Comparative Example 2]

The same operation as in Example 5 was carried out except that the microwave oscillation time was 3 minutes, and the surface of the gold deposited film was observed by AFM. As a result, aggregation of the gold deposited particles was recognized. This means that the gold deposited film was heated to high temperature. A surface profile obtained by observing the surface of the gold deposited film is illustrated in Fig. 8. As illustrated in Fig. 8, the surface roughness of the gold deposited film was greater than that of the gold deposited film which had not been subjected to the microwave oscillation. Therefore, with the microwave oscillation time of 3 minutes, the deposited particles were aggregated, but an yield stress thereof was still high, so that the gold deposited film was not sufficiently deformed by the compressive stress of 0.30 Pa. This might result in insufficient transcription of the surface unevenness of the flattening glass substrate. Note that, the microwave oscillation time was set to 20 minutes, but electric discharge did not occur.

Based on Example 4 and Comparative Example 2, optimal conditions of the heating and the compressive load in the microwave heating are considered as follows.

Whether or not the surface unevenness of the flattening glass substrate can be transcribed onto the surface of the gold deposited film greatly depends on the yield stress of the gold deposited film and the compressive stress which acts via the flattening glass substrate. In case where the yield stress is low, the surface unevenness of the flattening glass substrate can be transcribed onto the surface of the gold deposited film even if the compressive stress is low. However, in case where the yield stress is high, the surface unevenness of the flattening glass substrate cannot be transcribed onto the surface of the gold deposited film unless the compressive stress is made considerably high. Further, as the temperature of the gold deposited film is higher, the yield stress is lower. Particularly, in case where the gold deposited film becomes semi-liquid, the yield stress is extremely low.

In Example 4, the microwave was oscillated with an output of 950 W for 5 minutes so as to flatten the gold deposited film. The surface profile of the gold deposited film is illustrated in Fig. 7. In Example 4, the surface unevenness of the flattening glass substrate was transcribed onto the gold deposited film merely with the compressive stress of 0.30 Pa. Thus, it is considered that the gold deposited film became semi-liquid by heating with the microwave. While, in case where the microwave was oscillated for 3 minutes as in Comparative Example 2, as illustrated in Fig. 8, the surface unevenness of the flattening glass substrate was not sufficiently transcribed onto the gold deposited film with the compressive stress of 0.30 Pa. This may be based on the following reason: The temperature of the gold deposited film was slightly low, and the yield stress was still high as described above. Thus, by raising the compressive stress over the yield stress, it is possible to improve the surface roughness of the gold deposited film.

While, in case where the oscillation output of the microwave is raised, the gold deposited film may be semi-liquid in short time. It is more preferable that the oscillation output is higher in terms of a shorter processing time and mass production of the gold deposited chips. Note that, as a microwave oscillator for business use, there are various commercial machines whose oscillation output is 1.5 kW or further higher.

As described above, in order to transcribe the surface unevenness of the flattening glass substrate onto the surface of the gold deposited film, it is important to suitably set an amount of supplied microwave (oscillation output and oscillation time) and a compressive load (compressive stress).

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

### INDUSTRIAL APPLICABILITY

The method according to the present invention for producing the metallic thin film chip, the metallic thin film chip producing apparatus according to the present invention, and the metallic thin film according to the present invention are applicable not only to a measuring device etc., using a chip having a metallic thin film, which is based on SPR requiring the flatness, but also to flattening of the metallic thin film used as a laser reflector.

## Claims

1. A metallic thin film chip producing apparatus, flattening a surface of a metallic thin film formed on a first insulating substrate,
said metallic thin film chip producing apparatus comprising:
a placement table on which a metallic thin film chip is placed;
pressing means for causing a second insulating substrate to sandwich and press the metallic thin film of the metallic thin film chip, placed on the placement table, in a vertical direction with respect to the surface of the metallic thin film; and
heating means for heating the metallic thin film of the metallic thin film chip placed on the placement table.

2. The metallic thin film chip producing apparatus as set forth in claim 1, wherein the heating means includes magnetic flux generation means for generating a magnetic flux penetrating the metallic thin film of the metallic thin film chip placed on the placement table, and the magnetic flux causes the metallic thin film to be heated.

3. The metallic thin film chip producing apparatus as set forth in claim 2, wherein the heating means is a high frequency heater which includes a coil serving as the magnetic flux generation means.

4. The metallic thin film producing apparatus as set forth in claim 1, wherein the heating means heats the metallic thin film of the metallic thin film chip by irradiation of a microwave.

5. The metallic thin film chip producing apparatus as set forth in claim 4, wherein the heating means is a dielectric heater which includes microwave generation means for generating the microwave irradiated to the metallic thin film of the metallic thin film chip.

6. The metallic thin film chip producing apparatus as set forth in any one of claims 1 to 5, wherein each of the placement table and the pressing means is made of a material whose dielectric loss is small.

7. The metallic thin film chip producing apparatus as set forth in any one of claims 1 to 6 comprising a chamber for sealing up the metallic thin film chip placed on the placement table in vacuum or in an inert gas atmosphere.

8. The metallic thin film chip producing apparatus as set forth in any one of claims 1 to 6 comprising a chamber for shutting the metallic thin film chip placed on the placement table in a same atmosphere as a room air.

9. The metallic thin film chip producing apparatus as set forth in claim 1, 7, or 8 comprising fixation means for fixing the metallic thin film of the metallic thin film chip with the metallic thin film sandwiched by the second insulating substrate.

10. The metallic thin film chip producing apparatus as set forth in claim 4 or 5, wherein each of the placement table and the pressing means has a property which allows the microwave to pass therethrough.

11. The metallic thin film chip producing apparatus as set forth in any one of claims 1 to 10, wherein the metallic thin film is made of gold.

12. The metallic thin film chip producing apparatus as set forth in any one of claims 1 to 11, wherein the second insulating substrate has a surface which is in contact with the metallic thin film so that roughness of the surface is 1 nm or less.

13. A metallic thin film chip producing method for flattening a surface of a metallic thin film formed on a first insulating substrate,
said method comprising the steps of:
(i) causing a second insulating substrate to sandwich and press the metallic thin film in a vertical direction with respect to the surface of the metallic thin film; and
(ii) heating the metallic thin film.

14. The metallic thin film producing method as set forth in claim 13, wherein magnetic flux generation means generates a magnetic flux penetrating the metallic thin film so as to heat the metallic thin film in the step (ii).

15. The metallic thin film producing method as set forth in claim 13, wherein microwave generation means irradiates a microwave to the metallic thin film so as to heat the metallic thin film in the step (ii).

16. The metallic thin film producing method as set forth in any one of claims 13 to 15, wherein the steps (i) and (ii) are carried out in vacuum or an inert gas atmosphere or in a same atmosphere as a room air.

17. The metallic thin film producing method as set forth in any one of claims 13 to 16, wherein the metallic thin film is formed by deposition.
